(19) Europäisches Patentamt
European Patent Office
Office européen des brevets

(11) **EP 2 544 374 B1**

(12) **EUROPEAN PATENT SPECIFICATION**

(45) Date of publication and mention
of the grant of the patent:
**05.03.2014 Bulletin 2014/10**

(51) Int Cl.:
*H03M 3/04* *(2006.01)*   *H03M 7/00* *(2006.01)*

(21) Application number: **11305884.6**

(22) Date of filing: **08.07.2011**

(54) **Sigma delta digital to analog converter**

Sigma-Delta-Analog-Digital-Wandler

Convertisseur analogique-numérique delta-sigma

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.01.2013 Bulletin 2013/02**

(73) Proprietor: **Alcatel Lucent**
**75007 Paris (FR)**

(72) Inventors:
• **Dartois, Luc**
**91620 Nozay (FR)**

• **Benabes, Philippe**
**91620 Nozay (FR)**

(74) Representative: **Sciaux, Edmond**
**Alcatel-Lucent International**
**32, avenue Kléber**
**92700 Colombes (FR)**

(56) References cited:
**EP-A1- 1 435 695**   **WO-A1-97/48185**
**US-A1- 2004 208 249**   **US-B1- 6 232 899**

EP 2 544 374 B1

**Description**

The technical domain is the domain of digital converter, and particularly digital to analog converters using a sigma delta modulator.

It is known in the art, e.g. for amplification or base band to radio frequency transposition applications, to digitally implement a sigma delta digital to analog converter comprising a sigma delta multibit modulator with a feedback loop followed by a digital to analog converter. Said digital to analog converter introduces non linearities. Said non linearities can advantageously be corrected by pre-distorting the input signal through a feedback line feeding back the output signal of the sigma delta multibit modulator after applying a correction. Said correction is typically applied in a digital converter by using a correcting memory table. This correction principle implies that the correcting memory table can work at the speed of the digital clock sequencing the digital converter, without latency.

Document WO 9748185 is indicative of such prior art. It discloses a digital to analog converter for hearing aids and the like that includes a delta-sigma modulator and a duty cycle demodulator. The delta-sigma modulator converts medium rate, high resolution data into medium rate, medium resolution data, and the duty cycle demodulator converts the medium rate, medium resolution data into low resolution, high rate data. The duty cycle demodulator utilizes a lookup function to format the output data in a format having lowered transition rates, resulting in lower power use. The delta-sigma converter may include a correction factor in at least one of its feedback loops to compensate for the characteristics of the output data from the duty cycle demodulator.

Currently, correcting memory table is a component that appears to be rather slow, and as a trend, generally slower than needed clock speeds by a factor k comprised between 3 and 10. Correcting memory table is the limiting component when trying to reach high clock speeds. Applying a correction with such a correcting memory table then implies to reduce the overall clock speed and thus the reached performances by a factor k or to slow down the loop thus introducing instability.

A solution is expected to be able to use slow correcting memory table in a digital converter without either jeopardizing the performances or introducing instability.

The object of the invention is a sigma delta digital to analog converter, digitally sequenced by a clock, comprising a main line and a feedback line, the main line comprising: an input port able to receive a digital input signal of high binary resolution into the sigma delta digital to analog converter, a sigma delta multibit modulator comprising a linear filter $G(z)$ able to filter said digital input signal into a digital filtered signal, and a multibit quantifier able to quantify said digital filtered signal into a digital quantified signal of low binary resolution, a digital to analog converter able to convert said digital quantified signal into an analogical output signal, an output port able to deliver said analogical output signal, and the feedback line comprising a correcting memory table, able to process the digital quantified signal into a digital correcting signal, and an adder able to subtract said digital correcting signal from the digital input signal, in order to correct non linearities introduced by said digital to analog converter, wherein the correcting memory table time cycle is k times greater than the clock time cycle.

According to another feature, the feedback line further comprises a first unitary line feeding back the digital quantified signal and subtracting it from the digital input signal.

According to another feature, the feedback line further comprises: a second line comprising a linear filter $G'(z)$, being the quotient of the division of $G(z)$ by $z^{-k}$, and a correcting memory differential table in serial, able to filter and correct the digital quantified signal into a first correcting signal and an adder able to add said first correcting signal to the filtered digital input signal, a third line comprising a linear filter $P(z)$, being the remainder of the division of $G(z)$ by $z^{-k}$, and a correcting memory differential table in serial, able to filter and correct the digital quantified signal into a second correcting signal and an adder able to add said second correcting signal to the filtered digital input signal.

According to another feature, said correcting memory differential table of said second line comprises k duplicated pipelined elements each respectively shifted by one clock time cycle.

According to another feature, the lowest order terms of the linear filter $P(z)$ are truncated.

According to another feature, said third line further comprises a truncating mean able to truncate the digital quantified signal to its most significant bits, so as to reduce the binary resolution of said digital quantified signal in order said linear filter $P(z)$ and said correcting memory differential table can be implemented using only combinatorial functions.

According to another feature, said linear filter $G(z)$ comprises a cascaded integrator for each of its terms.

According to another feature, said linear filter $G'(z)$ comprises a cascaded integrator for each of its terms.

According to another feature, said cascaded integrator of $G'(z)$ is the same as said cascaded integrators of $G(z)$.

According to another feature, the correcting memory differential table is duplicated and associated to each of said term, each correcting memory table being adapted into an adapted correcting memory differential table incorporating the coefficient of its associated term.

According to another feature, said linear filter $P(z)$ comprises a cascaded integrator for each of its terms.

According to another feature, a correcting memory differential table is duplicated and associated to each of said term, each correcting memory table being adapted into an adapted correcting memory differential table incorporating the coefficient of its associated term.

Others features, details and advantages will become more apparent from the detailed illustrating description given hereafter with respect to the drawings on which:

- figure 1 is a schematic diagram of a sigma delta digital to analog converter, comprising a feedback line with a correcting memory table,
- figure 2 is a illustrative curve showing the principle of a correcting memory table,
- figure 3 is a schematic diagram showing a unitary feedback, according to one embodiment,
- figure 4 is a schematic diagram showing a decomposition of the correction between G'(z) and P(z), according to one embodiment,
- figure 5 is a schematic diagram showing a further decomposition of the correction, further detailing P(z), according to one embodiment,
- figure 6 is a schematic diagram showing a possible embodiment of filter G(z),
- figure 7 is a schematic diagram showing a possible embodiment of filters G(z) and G'(z),
- figure 8 is a schematic diagram showing a simplified possible embodiment of filters G(z) and G'(z),
- figure 9 is a schematic diagram showing a possible embodiment of a sigma delta digital to analog converter.

A sigma delta digital to analog converter, that is, a digitally implemented converter, is sequenced by mean of a clock, defining a clock time cycle. Such a converter can be implemented using a FPGA or equivalent digital computing technology.

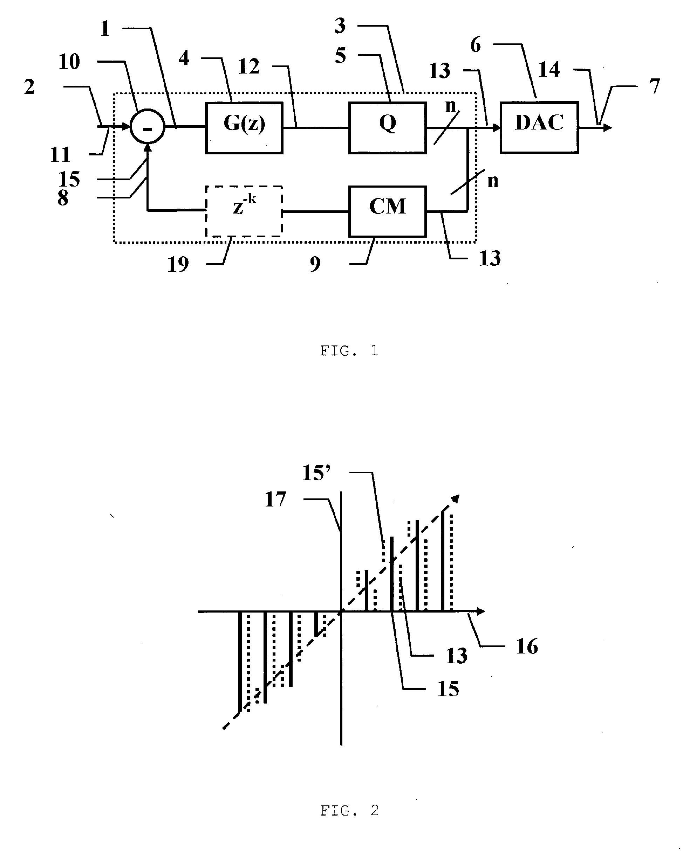

According to figure 1, a sigma delta digital to analog converter typically comprising a main line 1 and a feedback line 8. The main line 1 comprises, serially, from left to right in the plane of the figure, an input port 2 able to receive a digital input signal 11, an adder 10 able to subtract a digital correcting signal 15 received from the feedback line 8, a filter G(z) 4 and a multibit quantifier 5 able to modulate said digital input signal 11 into a digital quantified signal 13, a digital to analog converter 6 able to convert said digital quantified signal 13 into an analogical output signal 14, and an output port 7 able to deliver said analogical output signal 14.

As is known to the one skilled in the art said digital input signal can be either a real digital signal or a complex digital signal. The teachings provided herein can be applied to either real or complex signals.

As usual in a sigma delta architecture, the digital input signal 11 shows a high binary resolution, that is, each sample is defined by a digital word comprising between 10 and 16 bits. Due to the sigma delta modulation, the last digital signal before the digital to analog conversion, that is, the digital quantified signal 13, shows a rather low binary resolution, typically comprised between 1 and 5 bits.

Since the digital to analog converter 6 introduces non linearities, it is convenient to apply a correction by way of a correcting memory table 9. Said correcting memory table 9 is typically acting as a Y=f(X) function, where X is the input value, here the digital quantified signal 13, and Y is the output value replacing the input value by a corrected one.

As illustrated on figure 2, the correcting memory table 9 is based on a digital function. The digital function is figured on a diagram figuring X-axis 16 and Y-axis 17. For a given X value 13, the corresponding correcting Y value 15 is outputted. According to an embodiment, the digital function has previously been adapted and simplified, by applying a normative factor, in order to have Y=X for the biggest digital value. The function illustrated in figure 2 corresponds to a multibit quantifier 5 outputting a n=3 bits digital quantified signal 13. This leads to $2^n+1 = 8+1$ digital levels (zero included) for both X and Y values.

Accordingly, a correcting memory table 9 provides a correcting output value Y, when addressed by an input value X. Such correction is applied, as illustrated on figure 1 in a feedback line 8. So doing a pre distorting of the digital input signal is realized.

Such a correcting principle is only possible if said correcting memory table 9 is able to provide its output in less than a tick, that is, in less than one clock time cycle of the sigma delta digital to analog filter.

Practically it is not the case, and correcting memory tables 9 that can be found and implemented are generally slower. A stability problem occurs when such a correcting memory table 9 is too slow and can only provide an output in k clock time cycles, thus introducing an unwanted de facto $z^{-k}$ delay 19, as figured on figure 1.

One aim of the present disclosure is to provide ways of accommodating such $z^{-k}$ delay 19 while keeping stability and performances as high as possible.

A digital sigma delta multibit modulator 3 can be analyzed as comprising, in its main line, a linear filter G(z) 4 serially connected to a multibit quantifier 5. Said linear filter 4 is able to filter the digital input signal 11 and to provide a digital filtered signal 12. Said digital filtered signal shows the same binary resolution as the digital input signal 11 and the same low sampling frequency. Said multibit quantifier 5 is able to quantify the digital filtered signal 12 and to provide a digital quantified signal. Said digital quantified signal 13 shows a lower binary resolution compared to the digital input signal 11 or to the digital filtered signal 12, and a higher sampling frequency. A digital sigma delta multibit modulator 3 further comprises a feedback line 8 subtracting digital quantified signal 13 from the digital input signal 11.

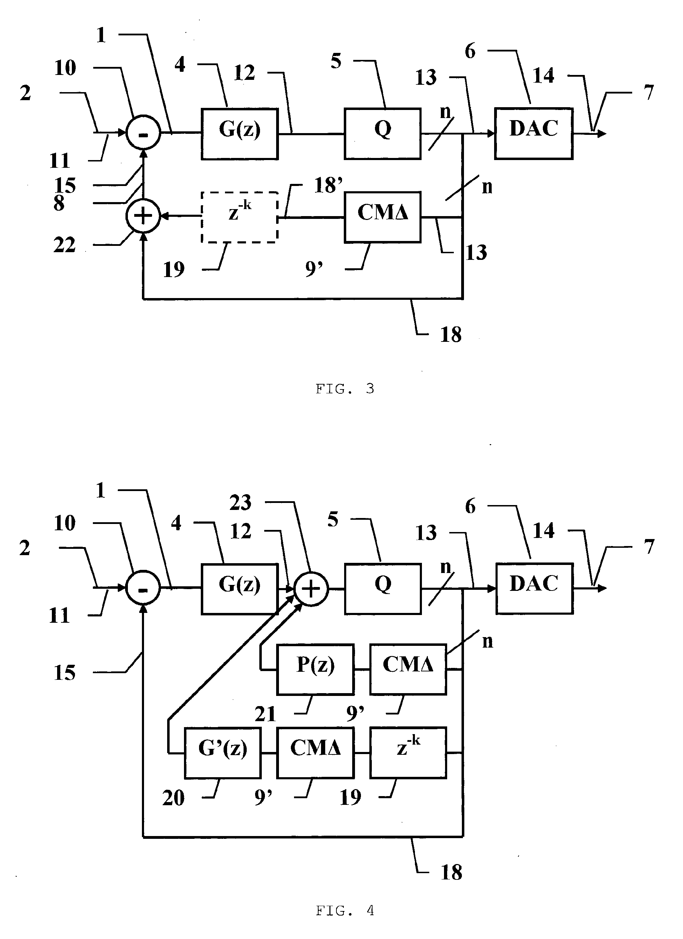

A first feature allowing at least reducing the destabilizing effect of a slow correcting memory table 9 is to consider a differential correction. Instead of applying a Y=f(X) correction, a Y = X + Δ correction is applied, where Δ is a differential correction, that is Δ = f(X)-X. As illustrated in figure 3, this is obtained by parting the feedback line 8 into a first line 18, said first line 18 being a unitary feedback. Said first line 18 only operates the X part of the Y = X + Δ correction. Another parallel feedback line 18' applies the Δ part of the Y = X + Δ. Said Δ part correction, as the X part correction, is computed from the digital quantified signal 13. It uses a correcting memory differential table 9'. The correcting memory differential table 9' acts the same way as the correcting memory table 9, but it contains Y = Δ corrections instead of Y = f(X) = X + Δ.

With reference to figure 2, the correcting memory differential table 9' contains, for a given X input value 13, the corresponding differential correcting Y output value 15'. Said Δ part is added through an adder 22. The X + Δ correction is then subtracted from the digital input signal 11 through the adder 10.

Such an arrangement still suffers from the use of a memory correction differential table 9', leading to a prejudicial $z^{-k}$ delay 19. However, a main feedback is applied through the unitary feedback line 18 without delay. This contributes to the stability of the whole loop, since the destabilizing influence of the differential correction line 18' is greatly reduced.

Another important feature to be able to use a slow correcting memory table, illustrated in figure 4, consists in dividing the feedback line 18' into two further lines. To do that, the filter G(z) is divided by $z^{-k}$. The linear filter G(z) can typically be expressed as a ratio of two polynomial functions $G(z) = \dfrac{N(z)}{D(z)}$. It is hypothesised that the order of the numerator N(z) is lesser or equal than the order of the denominator D(z) and that N(0)=0. It is then possible to divide G (z) by $z^{-k}$ in order to obtain $G(z) = \dfrac{N(z)}{D(z)} = P(z) + z^{-k}\dfrac{N'(z)}{D(z)} = P(z) + z^{-k}G'(z)$. P(z) is a polynomial of order k, with P(0)=0. N'(z) is a polynomial of the same order 1 as the denominator D(z).

Starting from a given G(z), for a given integer k, determined according to the delay $z^{-k}$, with respect to the clock time cycle, the one skilled in the art knows how to determine the P and N'/G' coefficients, that is 1+k unknown coefficients, out off the G coefficients, by solving a linear system by any known method.

Knowing the two linear filters G'(z) and P(z), being respectively the quotient and the remainder of the division of G(z) by $z^{-k}$, the previous feedback line 18' can further be parted into a second line comprising the linear filter G'(z) 20 and a correcting memory differential table 9' in serial, and a third line comprising the linear filter P(z) 21 and a correcting memory differential table 9' in serial.

Both second and third lines process the digital quantified signal 13. The second line outputs a first correcting signal and the third line outputs a second correcting signal. An adder 23 sums both first and second correcting signals with the filtered digital input signal 12.

So doing a $z^{-k}$ delay 19 has been managed and taken into account in the second/G' line. Said $z^{-k}$ delay 19 allows said second line to "lose" some time. k clock time cycles can be wasted without incurring any stability problem. This allows e.g. the correcting memory differential table 9' of said second/G' line to be k times slower than the clock, without any stability inconvenience. It is important to note that, contrary to all the others blocks, the $z^{-k}$ delay block 19 is not a real implemented block but a (authorised) consequence of the use of a correction memory table (differential) slower than the digital clock. This is indicated in figures by a dotted line box for said $z^{-k}$ delay block 19.

Since a correcting memory differential table 9' only delivers its output k clock time cycles later, once it has been used at a given clock time cycle, it becomes unavailable for the k-1 following cycles. An advantageous feature to correct this drawback is to implement a correcting memory differential table 9' by using k duplicated pipelined elementary correcting memory differential tables, each duplicating a correcting memory differential table 9' as described before, each of which being shifted by one clock time cycle. By doing so, a 1st elementary correcting memory differential table 9' is available on a 1st cycle, a ith elementary correcting memory differential table 9' is available on a ith cycle, i= 2..k-1, and a kth elementary correcting memory differential table 9' is available on a kth cycle, and so on, periodically on a period of k cycles.

It can be noted that the previous division by $z^{-k}$ is an exact operation, without any approximation. The embodiment of figure 4 is thus exactly equivalent to the initial embodiment of figure 1. However, the destabilising effect of the slow memory table has been limited and rejected to only the third/P line.

The problem still remains for the third/P line but with a reduced influence. The following features are intended to further reduce said eventually remaining inconveniences.

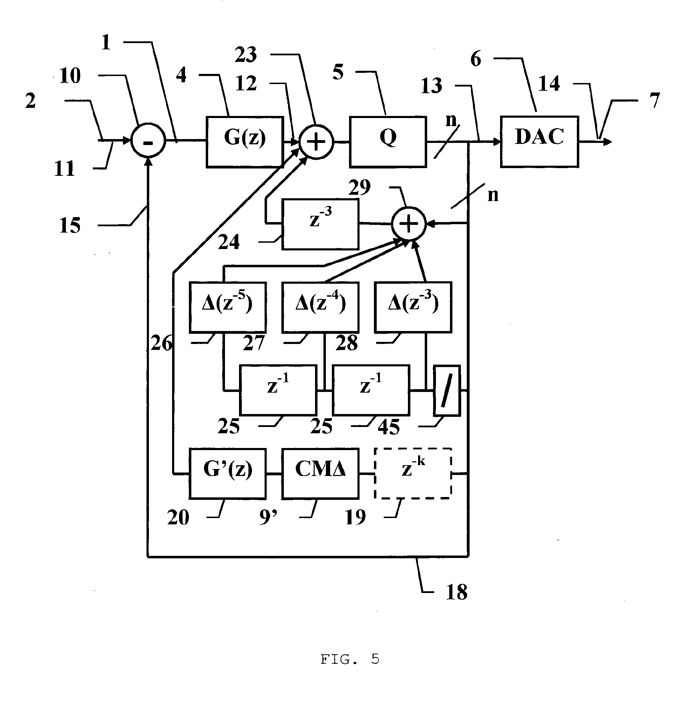

With reference to figure 5, the P line is modified as follow.

According to a first feature, the linear filter P(z) is truncated from its lowest order terms. For example, as illustrated, the three lowest order terms $z^0$ (P(0)=0), $z^{-1}$, $z^{-2}$ of the polynomial P(z) are truncated. Since P(z) represents only a coarse correction of the non linearities, these terms can be neglected. Some simulation studies have proved that such hypothesis is valid.

This feature together with a limited maximum order of the P polynomial allows a canonical decomposition of the P function in a limited number of simple lines comprising delay 25. As illustrated in figure 4, a P function, e.g. of maximum order 5, can be reduced to three simple lines corresponding to the $z^{-5}$, $z^{-4}$ and $z^{-3}$ terms. The P(z) filter 21 can then be implemented using two delays 25. The former correcting memory table 9' is replaced by three corresponding correcting means 26, 27, 28, each dedicated to one of the $z^{-5}$, $z^{-4}$ and $z^{-3}$ terms.

This allows a simplification of the correction to be applied so that the correcting means 26, 27, 28 in P line can be implemented using only combinatorial functions. The correcting functions 26, 27, 28 are designed to provide the most significant bits of the product between the correction applied to digital quantified signal 13 and respectively the coefficient of the $z^{-3}$, $z^{-4}$, $z^{-5}$ of P(z) polynomial. This can be realized using spare logic functions. The delay 24 represents the time required to cross theses logic functions. These combinatorial functions comprises only AND, OR, shifting functions, etc, and a correction memory table is no longer used. Since no correction memory table is used in the third / P line, the stability problem is then avoided for the P line also.

According to a second feature, if the binary resolution outputted by the multibit quantifier 4 is high, the third line may further comprise a truncating mean 45 able to truncate the digital quantified signal 13 to its most significant bits, so as to further reduce the binary resolution of said digital quantified signal 13. Since P(z) represents only a coarse correction, such an approximation of the signal by reducing the binary resolution is valid. Said feature helps simplifying the P line so that the correcting means 26, 27, 28 in P line can be more easily implemented using only combinatorial functions.

As is known by the one skilled in the art, a linear filter may be implemented by a integrator for each of its term. Each integrator comprised a delay 25 associated to a feedback loop 30. As needed, each integrator 25, 30, can be associated to a coefficient. Said coefficient can be located either in the feedback loop or at the output of each integrator 25, 30.

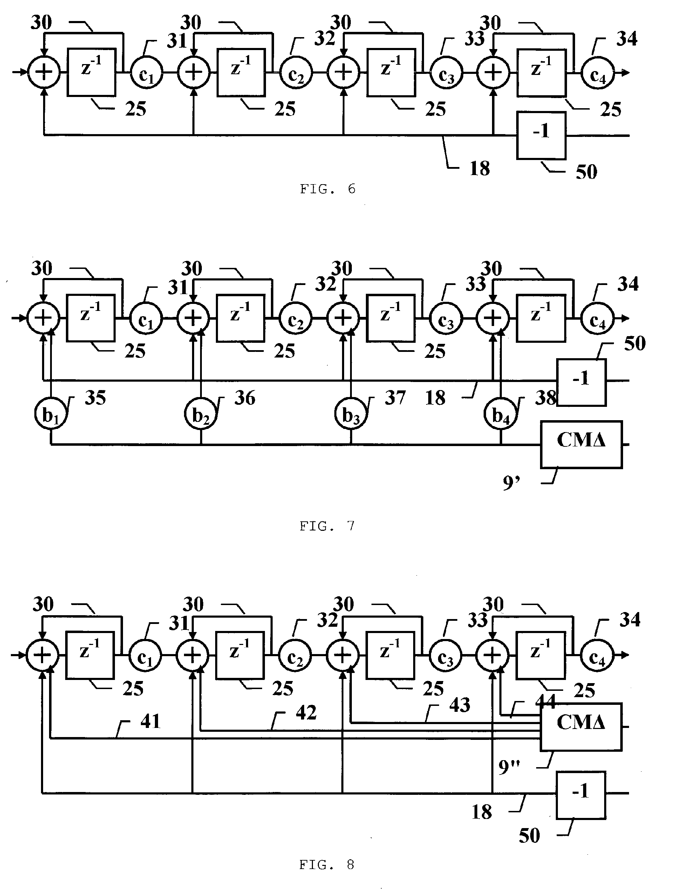

The figure 6 illustrates an exemplary filter function G(z) of order 4, canonically decomposed over four integrators 25, 30, using four coefficients $C_1$, 31, $C_2$, 32, $C_3$, 33, $C_4$, 34, located at the output of each integrator 25, 30. Figure 6 also includes the unitary feedback line 18 with an inverter 50.

Such a decomposition can also be applied to the filter function G'(z). Such decomposition also comprises a cascaded integrator 25, 30, for each of its terms. Since the function G'(z) share with function G(z) the same polynomial denominator D(z), the decomposition of G'(z) can advantageously reuses the integrators 25, 30, of the decomposition of G(z).

The diagram of figure 7 illustrates the decomposition of the G'(z) function and the G(z) function, corresponding to the illustrative function G(z) of figure 6. The figure 7 adds G'(z) by adding feedback loops respectively associated to $b_1$, 35, $b_2$, 36, $b_3$, 37, $b_4$, 38, coefficients. These coefficients 35-38 are determined in order to implement the numerator N' (z) of function G' (z) .

Figure 8 shows a diagram further simplifying the implementation of figure 7. In order to avoid using a multiplier to compute multiplications by coefficients $b_1..b_4$ of the correcting signal outputted from the correcting memory differential table 9', said correcting memory differential table 9' is replaced by a duplicated adapted correcting memory differential table 9" for each term of G'(z). The adaptation replaces a correcting memory differential table 9' by an adapted correcting memory differential table 9" incorporating the multiplication by the corresponding $b_1..b_4$ coefficient. The $i^{th}$ adapted correcting memory differential table 9" thus outputs a correcting signal equal to $b_i.Y = b_i.\Delta = bi.[f(X)-X)]$, for an input X. Thus in figure 8, the feedback line 41 carries the corrected signal already multiplied by $b_1$, the feedback line 42 carries the corrected signal already multiplied by $b_2$, the feedback line 43 carries the corrected signal already multiplied by $b_3$, and the feedback line 44 carries the corrected signal already multiplied by $b_4$.

As illustrated in figure 5, linear filter P(z) can also be decomposed, using a cascaded integrator for each of its terms.

While implementing P(z), the correcting memory table can also be duplicated into adapted correcting memory tables 26, 27, 28 associated to each term, the adaptation consisting in incorporating the coefficient of its associated term in the correcting value contained in the table.

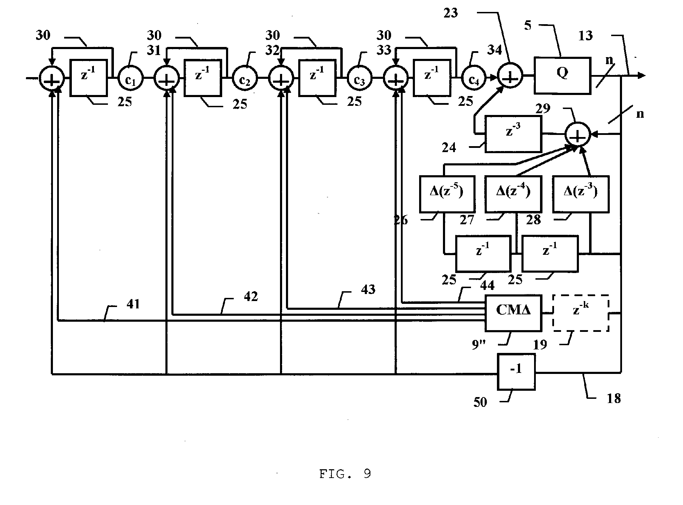

By combining the particular features of the different embodiments, and the illustrative fourth order decomposition of G(z) and G'(z) of the figures 6-8, one can implement a rather simple and efficient sigma delta digital to analog converter according to figure 9.

**Claims**

1. A sigma delta digital to analog converter, digitally sequenced by a clock, comprising a main line (1) and a feedback line (8), the main line (1) comprising:

- an input port (2) able to receive a digital input signal (11) of high binary resolution,
- a linear filter G(z) (4) able to filter said digital input signal (11) into a digital filtered signal (12), and

- a multibit quantifier (5) able to quantify said digital filtered signal (12) into a digital quantified signal (13) of low binary resolution,
- a digital to analog converter (6) able to convert said digital quantified signal (13) into an analogical output signal (14),
- an output port (7) able to deliver said analogical output signal (14),

and the feedback line (8) comprising:

- a first unitary line (18) feeding back the digital quantified signal (13) and an adder (10) subtracting it from the digital input signal (11), ***characterized in that*** the feedback line (8) further comprises: a second line comprising a linear filter G'(z) (20) being the quotient of the division of G (z) by $z^{-k}$, and a correcting memory differential table (9') in serial, able to filter and correct the digital quantified signal (13) into a first correcting signal, in order to correct non linearities introduced by said digital to analog converter (6), and an adder (23) able to add said first correcting signal to the digital filtered signal (12), and a third line comprising a linear filter P(z) (21), being the remainder of the division of G(z) by $z^{-k}$, and a correcting memory differential table (9') in serial, able to filter and correct the digital quantified signal (13) into a second correcting signal, in order to correct non linearities introduced by said digital to analog converter (6), and said adder (23) able to add said second correcting signal to the digital filtered signal (12), wherein the correcting memory differential table (9', 9") time cycle is k times greater than the clock time cycle.

2. The converter of claim **1**, wherein said correcting memory differential table (9') of said second line comprises k duplicated pipelined elements each respectively shifted by one clock time cycle.

3. The converter of claims **1** or **2**, wherein the lowest order terms of the linear filter P(z) are truncated.

4. The converter of any one of claims **1** to **3**, wherein said third line further comprises a truncating mean (45) able to truncate the digital quantified signal (13) to its most significant bits, so as to reduce the binary resolution of said digital quantified signal (13) in order said linear filter P(z) and said correcting memory differential table (9') are implemented using only combinatorial functions.

5. The converter of any one of claims **1** to **4**, wherein said linear filter G(z) (4) comprises a cascaded integrator (25, 30) for each of its terms.

6. The converter of claim **1** or **5**, wherein said linear filter G'(z) (20) comprises a cascaded integrator (25, 30) for each of its terms.

7. The converter of claim **6**, wherein said cascaded integrator (25, 30) of G'(z) is the same as said cascaded integrator (25, 30) of G(z).

8. The converter of claim **7**, wherein the correcting memory differential table 9' is duplicated and associated to each of said term, each correcting memory table being adapted into an adapted correcting memory differential table (9") incorporating the coefficient (35-38) of its associated term.

9. The converter of any one of claims **1** to **8**, wherein said linear filter P(z) (21) comprises a cascaded integrator (25, 30) for each of its terms.

10. The converter of claim **9**, wherein a correcting memory differential table is duplicated and associated to each of said term, each correcting memory table being adapted into an adapted correcting memory differential table (26-28) incorporating the coefficient of its associated term.

**Patentansprüche**

1. Sigma-Delta-Wandler für die Digital-Analog-Umsetzung, digital durch einen Taktgeber sequenziert, umfassend eine Hauptleitung (1) und eine Rückkopplungsleitung (8), wobei die Hauptleitung (1) umfasst:

- einen Eingangsport (2), welcher fähig ist, ein digitales Eingangssignal (11) mit hoher binärer Auslösung zu empfangen,
- einen Linearfilter G(z) (4), welcher fähig ist, das besagte digitale Eingangssignal (11) zu filtern, um ein gefiltertes digitales Signal (12) zu erhalten, und

- einen Multi-Bit-Quantisierer (5), welcher fähig ist, das besagte gefilterte digital Signal (12) in ein quantisiertes digitales Signal (13) mit niedriger binärer Auflösung zu quantisieren,
- einen Digital-Analog-Umsetzer (6), welcher fähig ist, das besagte quantisierte digitale Signal (13) in ein analoges Ausgangssignal (14) umzuwandeln;
- einen Ausgangsport (7), welcher fähig ist, das besagte analoge Ausgangssignal (14) auszugeben, und wobei die Rückkopplungsleitung (8) umfasst:
- eine erste unitäre Leitung (18), welche das quantisierte digital Signal (13) rückkoppelt, und einen Addieren (10), welcher das besagte Signal von dem digitalen Eingangssignal (11) subtrahiert, **dadurch gekennzeichnet, dass** die Rückkopplungsleitung (8) weiterhin umfasst: Eine zweite Leitung, umfassend einen Linearfilter G'(z) (20), welcher der Quotient der Division von G(z) durch $z^{-k}$ ist, und eine serielle Differenzkorrektur-Speichertabelle (9'), welche fähig ist, das quantisierte digitale Signal (13) zu filtern und zu einem ersten Korrektursignal zu korrigieren, um durch den besagten Digital-Analog-Umsetzer (6) verursachte Nichtlinearitäten zu korrigieren, und einen Addierer (23), welcher fähig ist, das besagte erste Korrektursignal zu dem gefilterten digitalen Signal (12) hinzuzufügen, und eine dritte Leistung mit einem Linearfilter P(z) (21), der der Rest der Division von G(z) durch z-k ist, und einer seriellen Differenzkorrektur-Speichertabelle (9'), welche fähig ist, das quantisierte digitale Signal (13) zu filtern und zu einem zweiten Korrektursignal zu korrigieren, um durch den besagten Digital-Analog-Umsetzer (6) verursachte Nichtlinearitäten zu korrigierten, und dem besagten Addierer (23), welcher fähig ist, das besagte zweite Korrektursignal zu dem gefilterten digitalen Signal (12) hinzuzufügen, wobei der Zeitzyklus der Differenzkorrektur-Speichertabelle (9', 9") k-Mal größer als der Taktzeitzyklus ist.

2. Wandler nach Anspruch **1**, wobei die Differenzkorrektur-Speichertabelle (9') der besagten zweiten Leitung k duplizierte Pipeline-Elemente umfasst, welche jeweils um einen Taktzeitzyklus verschoben sind.

3. Wandler nach Anspruch **1** oder **2**, wobei die Terme niedrigster Ordnung des Linearfilters P(z) abgeschnitten werden.

4. Wandler nach einem beliebigen der Anspruche **1** bis **3**, wobei die besagte dritte Leitung weiterhin ein Abschneidemittel (45) umfasst, welches fähig ist, das quantisierte digitale Signal (13) auf seine höchstwertigen Bits abzuschneiden, um die binäre Auflösung des besagten quantisierten digitalen Signals (13) zu reduzieren, so dass der besagte Linearfilter P(z) und die besagte Differenzkorrektur-Speichertabelle (9') ausschließlich unter Verwindung der kombinatorischen Funktionen implementiert werden.

5. Wandler nach einem beliebigen der Ansprüche **1** bis **4**, wobei der besagte Linearfilter G(z) (4) einen kaskadierten Integrator (25, 30) für einen jeden seiner Terme umfasst.

6. Wandler nach Anspruch **1** oder **5**, wobei der besagte Linearfilter G'(z) (20) einen kaskadierten Integrator (25, 30) für einen jeden seiner Terme umfasst.

7. Wandler nach Anspruch **6**, wobei der besagte kaskadierte Integrator (25, 30) von G'(z) derselbe wie der besagte kaskadierte Integrator (25, 30) von G(z) ist.

8. Wandler nach Anspruch 7, wobei die Differenzkorrektur-Speichertabelle 9' dupliziert und einem jeden der besagten Terme zugeordnet wird, wobei jede Korrekturspeichertabelle zu einer angepassten Differenzkorrektur-Speichertabelle (9"), welche den Koeffizienten (35-38) ihres zugeordneten Terms integriert, angepasst wird.

9. Wandler nach einem beliebigen der Ansprüche **1** bis **8**, wobei der besagte Linearfilter P(z) (21) einen kaskadierten Integrator (25, 30) für seinen jeden seiner Terme umfasst.

10. Wandler nach Anspruch **9**, wobei eine Differenzkorrektur-Speichertabelle dupliziert und einem jeden der besagten Terme zugeordnet wird, wobei jede Korrekturspeichertabelle zu einer angepassten Differenzkorrektur-Speichertabelle (26-28'), welche den Koeffizienten ihres zugeordneten Terms integriert, angepasst wird.


**Revendications**

1. Convertisseur numérique-analogique delta-sigma, séquencé numériquement par une horloge, comprenant une ligne principale (1) et une ligne de rétroaction (8), la ligne principale (1) comprenant :

   - un port d'entrée (2) pouvant recevoir un signal numérique d'entrée (11) de résolution binaire élevée,

EP 2 544 374 B1

- un filtre linéaire G(z) (4) pouvant filtrer ledit signal numérique d'entrée (11) en un signal numérique filtré (12), et
- un quantificateur multibit (5) pouvant quantifier ledit signal numérique filtré (12) en un signal numérique quantifié (13) de résolution binaire basse,
- un convertisseur numérique-analogique (6) prouvant convertir ledit signal numérique quantifié (13) en un signal analogique de sortie (14),
- un port de sortie (7) pouvant délivrer ledit signal analogique de sortie (14),
et la ligne de rétroaction (8) comprenant :
- une première ligne unitaire (18) renvoyant le signal numérique quantifié (13) et un additionneur (10) le soustrayant du signal numérique d'entrée (11), *caractérisé en ce que* la ligne de rétroaction (8) comprend en outre : une deuxième ligne comprenant un filtre linéaire G'(z) (20) qui est le quotient de la division de G(z) par z$^{-k}$, et une table différentielle de mémoire de correction (9') en série, prouvant filtrer et corriger le signal numérique quantifie (13) en un premier signal de correction, afin de corriger des non-linéarités introduites par ledit convertisseur numérique-analogique (6), et un additionner (23) pouvant additionner ledit premier signal de correction et le signal numérique filtré (12), et une troisième ligne comprenant un filtre linéaire P(z) (21), qui est le reste de la division de G(z) par z$^{-k}$, et une table différentielle de mémoire de correction (9') en série, pouvant filtrer et corriger le signal numérique quantifié (13) en un deuxième signal de correction, afin de corriger des non-linéarités introduites par ledit convertisseur numérique-analogique (6), et ledit additionneur (23) pouvant additionner ledit deuxième signal de correction et le signal numérique filtre (12), dans lequel le cycle de temps de la table différentielle de mémoire de correction (9', 9") est k fois supérieur au cycle de temps de l'horloge.

2. Convertisseur selon la revendication **1**, dans lequel ladite table différentielle de mémoire de correction (9') de ladite deuxième ligne comprend k éléments dupliqués en pipeline chacun étant respectivement décalé d'un cycle de temps de l'horloge.

3. Convertisseur selon la revendication **1** ou **2**, dans lequel les termes d'ordre inférieur du filtre linéaire P(z) sont tronqués.

4. Convertisseur selon l'une quelconque des revendications **1** à **3**, dans lequel ladite troisième ligne comprend en outre un moyen de tronquage (45) pouvant tronquer le signal numérique quantifié (13) en ses bits les plus significatifs, de sorte à réduire la résolution vinaire dudit signal numérique quantifié (13) afin que ledit filtre linéaire P(z) et que ladite table différentielle de mémoire de correction (9') soient mis en oeuvre en utilisent seulement des fonctions combinatoires.

5. Convertisseur selon l'une quelconque des revendications **1** à **4**, dans lequel ledit filtre linéaire G(z) (4) comprend un intégrateur en cascade (25, 30) pour chacun de ses termes.

6. Convertisseur selon la revendication **1** ou **5**, dans lequel ledit filtre linéaire G'(z) (20) comprend un intégrateur en cascade (25, 30) pour chacun de ses termes.

7. Convertisseur selon la revendication **6**, dans lequel ledit intégrateur en cascade (25, 30) de G'(z) est le même que ledit intégrateur en cascade (25, 30) de G(z).

8. Convertisseur selon la revendication **7**, dans lequel la table différentielle de mémoire de correction 9' est dupliquée et associée à chacun desdits termes, chaque table de mémoire de correction étant adaptée dans une table différentielle de mémoire de correction adaptée (9") intégrant le coefficient (35 à 38) de son terme associé.

9. Convertisseur selon l'une quelconque des revendications **1** à **8**, dans lequel ledit filtre linéaire P(z) (21) comprend une intégrateur en cascade (25, 30) pour chacun de ses termes.

10. Convertisseur selon la revendication **9**, dans lequel une table différentielle de mémoire de correction est dupliquée et associée à chacun desdits termes, chaque table de mémoire de correction étant adaptée dans une table différentielle de mémoire de correction adaptée (26 à 28) intégrant le coefficient de son terme associé.

8

FIG. 1

FIG. 2

FIG. 3

FIG. 4

FIG. 5

FIG. 6

FIG. 7

FIG. 8

FIG. 9

**EP 2 544 374 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9748185 A